# EUROPÄISCHE PATENTSCHRIFT

(11) **EP 1 244 515 B1**
(45) Veröffentlichungstag und Bekanntmachung des Hinweises auf die Patenterteilung: **20.08.2003**
(21) Anmeldenummer: 00990721.3
(22) Anmeldetag: 12.12.2000
(51) Int. Cl.: B01J 19/00, C23C 14/34

(54) **HERSTELLUNG VON MATERIALBIBLIOTHEKEN DURCH SPUTTERVERFAHREN**
PRODUCTION OF MATERIAL LIBRARIES USING SPUTTER METHODS
PRODUCTION DE BIBLIOTHEQUES DE MATERIAUX PAR PULVERISATION CATHODIQUE

(30) Priorität: 13.12.1999 DE 19959972
(43) Veröffentlichungstag der Anmeldung: 02.10.2002
(73) Patentinhaber: hte Aktiengesellschaft the high throughput experimentation company, 69123 Heidelberg (DE)
(72) Erfinder: SCHUNK, Stephan, 69115 Heidelberg (DE); DEMUTH, Dirk, 68161 Mannheim (DE); HIBST, Hartmut, 69198 Schriesheim (DE)
(74) Vertreter: Ricker, Mathias, Dr.
(86) Internationale Anmeldenummer: EP0012600
(87) Internationale Veröffentlichungsnummer: WO01043865

(56) Entgegenhaltungen:
- WO-A-98/47613
- WO-A-99/19066
- US-A- 4 591 417
- US-A- 4 814 056
- US-A- 5 460 853
- HANAK J J: "THE MULTIPLE-SAMPLE CONCEPT IN MATERIALS RESEARCH: SYNTHESIS, COMPOSITIONAL ANALYSIS AND TESTING OF ENTIRE MULTICOMPONENT SYSTEMS" JOURNAL OF MATERIALS SCIENCE,CHAPMAN AND HALL LTD,GB, Bd. 5, 1970, Seiten 964-971, XP000908955 ISSN: 0022-2461
- VAN DOVER R B, ET AL.: "Discovery of a useful thin-film dielectric using a composition-spread approach" NATURE, Bd. 392, März 1998 (1998-03), Seiten 162-164, XP002166598

## Beschreibung

Die Erfindung betrifft Verfahren zur kombinatorischen Herstellung einer Bibliothek von Materialien im Oberflächenbereich eines flächigen Substrats durch Sputtem.

Die parallelisierte Herstellung und Testung von Materialien mit geeigneten physikalischen und/oder chemischen Eigenschaften ist ein Gebiet in der Materialforschung, das gegenwärtig stark an Beachtung gewinnt.

Die WO 98/47613 offenbart eine Reihe von Verfahren, mit denen mittels Sputter-, CVD- oder PVD-Techniken Bibliotheken von potentiell interessanten Materialien erzeugt werden können. Im Kern betrifft diese Anmeldung die Verwendung geeigneter Maskentechniken, die eine definierte Abscheidung von mindestens zwei Komponenten (die als getrennte Substrate vorliegen) auf einem Substrat ermöglicht, wodurch Kompositmaterialien erhalten werden. Weiterhin können durch das Verfahren durch Erzeugung von Gradienten auf dem gesputterten Substrat komplette Bibliotheken von Materialien unterschiedlicher Zusammensetzung erzeugt werden.

Die Verwendung zahlreicher unterschiedlicher Masken, die exakt positioniert werden müssen, um zuverlässige Ergebnisse zu erhalten, macht das beschriebene Verfahren aufwendig in der Durchführung.

Aufgabe der vorliegenden Erfindung ist die Bereitstellung eines Verfahrens zur kombinatorischen Herstellung einer Bibliothek von Materialien, das die Nachteile des bekannten Verfahrens vermeidet.

Die Aufgabe wird erfindungsgemäß gelöst durch ein Verfahren zur kombinatorischen Herstellung einer Bibliothek von Materialien in Form einer zweidimensionalen Matrix im Oberflächenbereich eines flächigen Substrats durch Sputtern, wobei das zum Sputtem verwendete flächige Target parallel zum flächigen Substrat angeordnet ist und Oberflächenbereiche unterschiedlicher chemischer Zusammensetzung (z. B. Mosaiktarget) aufweist.

Zudem wird die Aufgabe erfindungsgemäß gelöst durch ein Verfahren zur kombinatorischen Herstellung einer Bibliothek von Materialien im Oberflächenbereich eines flächigen Substrats durch Sputtern gemäß Anspruch 1 wobei ein bandförmiges Substrat in Längsrichtung verschoben wird und mindestens zwei zum Sputtern verwendete Targets unterschiedlicher chemischer Zusammensetzungen über dem Band entlang der Verschieberichtung angeordnet sind.

Beim vorliegenden Verfahren entfällt die Nutzung von Masken zur Erzeugung der erwünschten Bibliotheken, so daß die Herstellung von Bibliotheken wesentlich vereinfacht wird.

Die grundsätzliche Idee des Mosaiktargets besteht darin, daß für den Sputterprozeß ein stofflich inhomogenes Target zum Sputtem benutzt wird, wobei zunächst durch den Sputterprozeß eine Matrix mit unbekannter Zusammensetzung erzeugt wird. Erst nach erfolgreicher Testung auf die erwünschte physikalische oder chemische Eigenschaft erfolgt eine Analyse der Zusammensetzung der die Anforderungen erfüllenden Materialien. Durch eine Belegung des Grundtargets mit verschiedenen anderen Komponenten wird beim Sputterprozeß auf der gesputterten Matrix ein Gradient der unterschiedlichen Komponenten erzeugt. Dieser Gradient kann nützlich sein, um Legierungen von Metallen und/oder Nichtmetallen, gemischte Oxide von Metallen und/oder Nichtmetallen oder andere Verbindungsklassen unterschiedlicher Zusammensetzungen herzustellen, sofern diese mittels Sputterverfahren zugänglich sind. Durch geeignete räumliche Anordnung der Komponenten auf dem Grundtarget kann die gesputterte Matrix in Sektoren aufgeteilt werden, in denen, nach Art der Mengenlehre, es zu einer Anreicherung jeweils einer der Komponenten kommt, so daß ein möglichst großer Bereich der potentiell herstellbaren Komponentenmischungen erzeugt werden kann.

Das Sputtern beinhaltet die Zerstäubung einer Festkörperfläche durch Beschuß mit energiereichen Ionen wie O⁺ oder Ar⁺ oder Neutralteilchen (FAB, fast atom beam bombardment). Beim Sputtern wird die kinetische Energie des Primärteilchens, also der Ionen oder Neutralteilchen, durch Stöße auf die Atome des Festkörpers (Target) verteilt. Wird bei diesem Verfahren einem Oberflächenatom genügend Energie übertragen, um die Oberflächenbindungsenergie zu überwinden, kann dieses als freies Teilchen den Festkörper verlassen und auf einem Substrat abgeschieden werden. Auf diese Weise können einzelne Atome, Ionen, wie auch Cluster erzeugt und auf Substraten abgeschieden werden. Die kinetischen Energie der Ionen oder Neutralteilchen beträgt in der Regel 0,1 bis 20 keV. Geeignete Sputter-Verfahren sind bekannt. Da die freigesetzten Teilchen verglichen mit thermisch verdampften Teilchen höhere Energien besitzen, können sie zur Abscheidung dünner Schichten auf Substraten verwendet werden, vgl. sogenannte PVD-Verfahren (Physical Vapor Deposition, physikalische Dampfabscheidung).

Durch Wahl eines Targets mit Oberflächenbereichen unterschiedlicher Zusammensetzung können Zusammensetzungsgradienten des auf einem Substrat erhaltenen Materials erzeugt werden. Derartige Gradienten können erfmdungsgemäß zudem dadurch erreicht werden, daß das Materialsubstrat räumlich entlang einer Reihe von Targets verschoben wird, wobei die Targets phasenverschoben angesteuert werden.

Bislang wurden Sputter-Verfahren zur Erzeugung möglichst homogener Zusammensetzungen und nicht zur Erzeugung von Gradienten eingesetzt, vgl. Ullmanns Encyclopedia of Industrial Chemistry, 6^{th} Edition, 1998 Electronic Release, Wiley-VCH, Weinheim, Deutschland.

Der Begriff "Bibliothek von Materialien" bedeutet, daß eine Vielzahl unterschiedlich zusammengesetzter Materialien auf einem Substrat erzeugt wird. Vorzugsweise werden mindestens 10, besonders bevorzugt mindestens 100 unterschiedliche Materialien auf dem Substrat gebildet.

Der Ausdruck "im Oberflächenbereich" bedeutet, daß die Materialien beispielsweise auf einem flächigen Substrat gebildet werden, wobei die gesputterten Metalle oder Nichtmetalle nicht in das Substrat eindringen. Dies ist insbesondere bei glatten Keramik-, Glas-, Kunststoff-, Metall- oder Kohlesubstraten der Fall. Es können jedoch auch entsprechende poröse Trägermaterialien verwendet werden, wobei die gesputterten Metalle oder Nichtmetalle zumindest in die oberflächlichen Poren eindringen. Dabei wird erfindungsgemäß das Material in der obersten Schicht des flächigen Substrats gebildet, d. h. im Oberflächenbereich.

Der Ausdruck "flächiges Substrat" bedeutet ein Substrat, das sich in zwei Raumrichtungen wesentlich stärker erstreckt als in der dritten Raumrichtung. Das flächige Substrat muß nicht eben sein, es kann sich beispielsweise um eine Reihe von Vertiefungen oder Schälchen auf oder in einer Platte handeln. Beispielsweise kann es sich um eine Tüpfelplatte handeln oder eine entsprechende Platte, die in regelmäßigen Abständen Vertiefungen aufweist. Insbesondere kann das poröse Trägermaterial auch in Form von Formkörpern beliebiger Gestalt vorliegen, beispielsweise in Form aufgeschnittener und in zwei Hälften aufgetrennter Röhrchen, die für einen nachfolgenden katalytischen Test wieder zusammengefügt werden können. Bevorzugt sind poröse Trägermaterialien aus Keramiken, Metallen oder Aktivkohlen. Beispiele derartiger Träger sind in der DE-A-198 05 719 als Hilfsträger beschrieben.

Die genaue Ausgestaltung des flächigen Substrats ist nicht beschränkt. Vorzugsweise ist das flächige Substrat in einzelne definierte Plätze unterteilt, die räumlich voneinander abgegrenzt sind.

Der Ausdruck "flächiges Target" bedeutet ein Target, das sich in zwei Raumrichtungen wesentlich stärker erstreckt als in der dritten Raumrichtung. Das flächige Target muß ebenso wie das flächige Substrat nicht notwendigerweise eben sein. Es kann auf der Oberfläche mindestens teilweise mit flächigen Metallund/oder Nichtmetallstücken mindestens eines vom Target unterschiedlichen Metalls oder Nichtmetalls versehen sein. Die Befestigung kann z. B. durch Kleben, Löten oder Verschweißen erfolgen. Die Raumreichung kann dann beim Sputtem gewählt werden. Das flächige Target kann beispielsweise horizontal angeordnet sein und auf der Oberfläche mindestens teilweise mit flächigen Metall- und/oder Nichtmetallstücken mindestens eines vom Target unterschiedlichen Metalls oder Nichtmetalls belegt sein. In diesem Fall wird das Target von oben gesputtert.

Das flächige Target ist parallel zum flächigen Substrat angeordnet. Hierdurch wird sichergestellt, daß sich auf dem flächigen Substrat eine Matrix unterschiedlicher Materialien beim Sputtem bildet, da auf dem Target Bereiche unterschiedlicher Materialzusammensetzungen vorliegen. Geringfügige Abweichungen von der Parallelität von beispielsweise ± 5°, vorzugsweise ± 2° können dabei toleriert werden.

Das Target weist Oberflächenbereiche unterschiedlicher Zusammensetzung auf. Dabei liegen an mindestens zwei unterschiedlichen räumlichen Positionen des Targets unterschiedliche Oberflächenzusammensetzungen vor.

Beispielsweise kann ein Target mit Folienstücken unterschiedlicher Metallund/oder Nichtmetallfolien an unterschiedlichen Positionen belegt werden, wodurch in einfacher Weise ein flächiges Target mit Oberflächenbereichen unterschiedlicher chemischer Zusammensetzung erhalten wird.

Vorzugsweise ist das Target mit Metall- und/oder Nichtmetallstücken belegt, die ausgewählt sind aus Metallen der Gruppen Ib, IIb, IIIb, IVb, Vb, VIb, VIIb und VIII, Lanthanoiden und Actionoiden sowie Metallen und Nichtmetallen der Gruppen Ia, IIa, IIIa, IVa, Va und VIa des Periodensystems der Elemente. Das Sputterverfahren kann für einen großen Bereich an Metallen und Nichtmetallen durchgeführt werden.

Vorzugsweise liegen auf dem Target zwei bis zwanzig, besonders bevorzugt zwei bis zehn, insbesondere zwei bis fünf unterschiedliche Metall- und/oder Nichtmetallstücke vor.

Beispielsweise kann als Target ein Edelmetalltarget wie ein Goldtarget eingesetzt werden, das mit anderen Edelmetallfolienstücken wie Platin- und Palladiumfolienstücken in geeigneter Weise belegt wird. Es kann auch beispielsweise ein Eisentarget mit Folienstücken der Elemente Gold, Platin und Nickel in geeigneter Weise belegt werden. Die Folienstücke können dabei zufällig oder nach bestimmten Ordnungsprinzipien auf dem Target angeordnet werden. Vorzugsweise werden Folienstücke unterschiedlicher Zusammensetzung so angeordnet, daß sich auf dem flächigen Substrat möglichst unterschiedliche Materialzusammensetzungen in unterschiedlichen Bereichen ergeben (Mosaiktarget). Auf dem flächigen Substrat werden dabei vorzugsweise sowohl die Zusammensetzungen gemäß der einzelnen Folienstücke erhalten, wie auch Gemische von zweien und mehreren davon.

Die gesputterte Matrix kann auch in geordnete Sektoren aufgeteilt werden, beispielsweise in eine zweidimensionale Matrix, die nach kombinatorischen Prinzipien mit den Folienstücken belegt wird.

Die Sputterparameter werden erfindungsgemäß so gewählt, daß sich eine (überlappende) Verteilung der unterschiedlichen Komponenten auf dem Substrat und damit die jeweilige Zusammensetzung der unterschiedlichen Proben ergibt.

Die erhaltene Schichtdicke an gesputtertem Material kann von einer monoatomaren Schicht bis etwa 500 µm variieren.

Die Erfindung betrifft zudem ein Verfahren zur kombinatorischen Herstellung einer Bibliothek von Materialien im Oberflächenbereich eines flächigen Substrats durch Sputtern gemäß Anspruch 1, wobei ein bandförmiges Substrat in Längsrichtung verschoben wird und mindestens zwei zum Sputtern verwendete Targets unterschiedlicher chemischer Zusammensetzung über dem Band entlang der Verschieberichtung angeordnet sind.

Hierbei handelt es sich um ein kontinuierliches Verfahren, vorzugsweise zur Beschichtung von Bändern durch Verfahren des Bandes in eine Richtung unter gleichzeitiger Beschichtung durch unterschiedliche Targets mittels Sputtern. Anstelle eines mit beispielsweise Folien belegten Targets werden mehrere Targets mit unterschiedlicher Zusammensetzung über dem verfahrbaren Band in Bandrichtung angeordnet. Dabei werden die zwei oder mehr Targets vorzugsweise so phasenverschoben angesteuert, daß auf dem bandförmigen Substrat in Bandrichtung unterschiedliche Materialien abgeschieden werden. Dies kann beispielsweise dadurch erreicht werden, daß die Stromstärke der einzelnen Targets bei mit konstanter Geschwindigkeit laufendem Band als Funktion der Zeit für die einzelnen Komponenten phasenverschoben variiert wird. Das resultierende Band besitzt dann auf seiner ganzen Länge unterschiedliche Zusammensetzungen und kann in den einzelnen Abschnitten auf nützliche Eigenschaften getestet werden. Geeignete Bandmaterialien sind Metallbänder, -netze, -gewebe, -gestricke oder -filze, die für die Testung auf nützliche katalytische Eigenschaften in Stücke geschnitten und anschließend untersucht werden können. Sie können beispielsweise zu Röhren verarbeitet werden. Die Art des Bandmaterials ist nicht auf Metalle beschränkt, sondern der Träger kann wie vorstehend beschrieben auch aus Glas, Keramik oder Aktivkohle aufgebaut sein. Als Keramiken kommen insbesondere Oxide, Nitride und Carbide als Glaskeramik oder Sinterquarz zum Einsatz. Es kann wiederum auf die DE-A-198 05 719 verwiesen werden.

Beispielsweise können drei hintereinander angeordnete unterschiedliche Targets entsprechend einer jeweils verschobenen Sägezahnfunktion angesteuert werden, so daß jeweils nur zwei Targets auf eine Stelle des Substrats wirken und binäre Mischungen mit Gradienten erhalten werden.

Die Erfindung betrifft auch ein Verfahren zur kombinatorischen Testung von Bibliotheken von Materialien, die nach einem der vorstehenden Verfahren erhalten werden, bei dem einzelne definierte Plätze des Substrats mit physikalischen und/oder chemischen Verfahren auf eine gewünschte Eigenschaft untersucht werden und sodann die Zusammensetzung der definierten Plätze des Substrats, für die die gewünschte Eigenschaft gefunden wurde, analysiert wird. Die Analyse kann auch wie in DE-A-198 05 719 beschrieben durchgeführt werden.

Die Erfindung wird nachstehend anhand von Beispielen näher erläutert:

Ein rundes scheibenförmiges GeSb₂Te₄-Target mit einem Durchmesser von 15 cm wurde mit Co-Chips mit einem Durchmesser von 1 cm in einem Abstand von 5 cm belegt. Auf der durch Sputtern erhaltenen Matrix wurden Kobaltgehalte von 1,8 bis 3,6% gemessen. Hieraus geht hervor, daß durch inhomogene Anordnung derartiger Metallchipbelegungen auf einem Target auch inhomogene Beschichtungen auf einer Matrix erhalten werden, da sich die inhomogene Belegung des Targets auf die gesputterte Fläche überträgt.

## Patentansprüche

1. Verfahren zur kombinatorischen Herstellung einer Bibliothek von Materialien im Oberflächenbereich eines flächigen Substrats durch Sputtern, wobei ein bandförmiges Substrat in Längsrichtung vorschoben wird und mindestens zwei zum Sputtern verwendete Targets unterschiedlicher chemischer Zusammensetzungen über dem Band entlang der Verschieberichtung angeordnet sind, **dadurch gekennzeichnet, dass** die zwei oder mehr Targets so phasenverschoben angesteuert werden, dass auf dem bandförmigen Substrat in Bandrichtung unterschiedliche Materialien abgeschieden werden.

2. Verfahren nach Anspruch 1, **dadurch gekennzeichnet, dass** das Target auf der Oberfläche mindestens teilweise mit flächigen Metall- und/oder Nichtmetallstücken mindestens eines vom Target unterschiedlichen Metalls oder Nichtmetalls versehen ist.

3. Verfahren nach Anspruch 1 oder 2, **dadurch gekennzeichnet, dass** mit energiereichen Ionen oder Neutralteilchen gesputtert wird.

4. Verfahren nach Anspruch 2 oder 3, **dadurch gekennzeichnet, dass** das Target mit Metall- und/oder Nichtmetallstücken belegt ist, die ausgewählt sind aus Metallen der Gruppen Ib, IIb, IIIb, IVb, Vb, VIb, VIIb und VIII, Lanthanoiden und Actinoiden und Metallen und Nichtmetallen der Gruppen Ia, IIa, IIIa, IVa, Va und VIa des Periodensystems der Elemente.

5. Verfahren nach einem der Ansprüche 1 bis 4, **dadurch gekennzeichnet, dass** das bandförmige Substrat in einzelne definierte Plätze unterteilt ist, die räumlich voneinander abgegrenzt sind.

6. Verfahren nach einem der Ansprüche 1 bis 5, **dadurch gekennzeichnet, dass** das bandförmige Substrat zumindest oberflächlich ein poröses Trägermaterial aufweist, das in Form von Formkörpern vorliegen kann.

7. Verfahren nach einem der Ansprüche 1 bis 6, **dadurch gekennzeichnet, dass** das flächige Substrat zumindest oberflächlich aus Glas, Keramik, Metall und/oder Aktivkohle aufgebaut ist.

8. Verfahren zur kombinatorischen Testung von Bibliotheken von Materialien, die nach einem Verfahren gemäß einem der Ansprüche 1 bis 7 erhalten werden, bei dem einzelne definierte Plätze des Substrats mit physikalischen und/oder chemischen Verfahren auf eine gewünschte Eigenschaft untersucht werden und sodann die Zusammensetzung der definierten Plätze des Substrats, für die die gewünschte Eigenschaft gefunden wurde, a-naiysiert wird.

## Claims

1. A process for the combinatorial production of a library of materials in the surface region of a substrate area by sputtering, a ribbon-shaped substrate being shifted in the longitudinal direction and at least two targets of different chemical compositions which are used for the sputtering being arranged above the ribbon along the direction of shifting, wherein the two or more targets are targeted in a phase-shifted manner in such a manner that different materials are deposited on the ribbon-shaped substrate in the direction of the ribbon.

2. A process as claimed in claim 1, wherein the target is provided, on the surface, at least in part with areas of metal pieces and/or nonmetal pieces of at least one metal or nonmetal which is different from the target.

3. A process as claimed in claim 1 or 2, wherein sputtering is carried out using high-energy ions or neutral particles.

4. A process as claimed in claim 2 or 3, wherein the target is overlaid with metal pieces and/or nonmetal pieces which are selected from metals of groups Ib, IIb, IIIb, IVb, Vb, VIb, VIIb and VIII, lanthanides and actinides, and metals and nonmetals of groups Ia, IIa, IIIa, IVa, Va, and VIa of the Periodic Table of the Elements.

5. A process as claimed in one of claims 1 to 4, wherein the ribbon-shaped substrate is subdivided into individually defined sites which are spatially delimited from one another.

6. A process as claimed in one of claims 1 to 5, wherein the ribbon-shaped substrate has at least on the surface a porous support material which can be present in the form of shaped bodies.

7. A process as claimed in one of claims 1 to 6, wherein the planar substrate is made up, at least on the surface, of glass, ceramics, metal and/or activated carbon.

8. A process for the combinatorial testing of libraries of materials which are obtained by a process as claimed in one of claims 1 to 7, in which individually defined sites of the substrate are analyzed for a desired property by physical and/or chemical methods, and then the composition of the defined sites of the substrate for which the desired property was found is analyzed.

## Revendications

1. Procédé de production combinatoire d'une bibliothèque de matériaux dans la zone superficielle d'un substrat plan par pulvérisation cathodique, dans lequel un substrat en forme de bande est déplacé en direction longitudinale et au moins deux cibles utilisées pour la pulvérisation cathodique et de composition chimique différente sont disposées sur la bande le long de la direction du déplacement, **caractérisé en ce que** les deux ou plus de deux cibles sont commandées avec un décalage de phases tel que des matériaux différents soient déposés sur le substrat en forme de bande dans la direction de la bande.

2. Procédé selon la revendication 1, **caractérisé en ce que** la cible sur la surface est au moins en partie munie de pièces planes de métal ou de non-métal d'au moins un métal ou un non-métal différent de la cible.

3. Procédé selon la revendication 1 ou 2, **caractérisé en ce que** la pulvérisation cathodique est opérée au moyen de particules neutres ou d'ions à haute énergie.

4. Procédé selon la revendication 2 ou 3, **caractérisé en ce que** la cible est recouverte de pièces de métal ou de non-métal, choisis parmi des métaux des groupes Ib, IIb, IIIb, IVb, Vb, VIb, VIIb et VIII, les lanthanides et les actinides ainsi que des métaux et des non-métaux des groupes Ia, IIa, IIIa, IVa, Va et VIa du système périodique des éléments.

5. Procédé selon l'une des revendications 1 à 4, **caractérisé en ce que** le substrat en forme de bande est subdivisé en zones individuelles définies, qui sont spatialement délimitées les unes vis-à-vis des autres.

6. Procédé selon l'une des revendications 1 à 5, **caractérisé en ce que** le substrat en forme de bande présente au moins en surface un matériau de support poreux, qui peut être sous la forme de corps façonnés.

7. Procédé selon l'une des revendications 1 à 6, **caractérisé en ce que** le substrat plan est constitué au moins en surface de verre, céramique, métal et/ou charbon actif.

8. Procédé d'essai combinatoire de bibliothèques de matériaux, lesquelles sont obtenues par un procédé selon l'une des revendications 1 à 7, dans lequel des zones individuelles définies du substrat sont étudiées par des procédés physiques et/ou chimiques quant à une propriété souhaitée et que la composition des zones définies du substrat pour lesquelles a été trouvée la propriété souhaitée est ensuite analysée.
